(19) Europäisches Patentamt
European Patent Office
Office européen des brevets

(11) **EP 2 306 643 A1**

(12) **EUROPEAN PATENT APPLICATION**

(43) Date of publication:
06.04.2011 Bulletin 2011/14

(51) Int Cl.:
*H03H 9/05* (2006.01)  *H03H 9/10* (2006.01)

(21) Application number: 10174764.0

(22) Date of filing: 31.08.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(30) Priority: 30.09.2009 JP 2009228971
05.03.2010 JP 2010049883

(71) Applicant: Seiko Instruments Inc.
Chiba-shi, Chiba (JP)

(72) Inventor: Yoshida, Yoshifumi
Chiba-shi, Chiba (JP)

(74) Representative: Cloughley, Peter Andrew
Miller Sturt Kenyon
9 John Street
London WC1N 2ES (GB)

(54) **Piezoelectric resonator, oscillator and oscillator package**

(57)     Provided is a piezoelectric resonator having a structure in which the piezoelectric resonator chip is mounted on a silicon substrate without deteriorating a characteristic. The piezoelectric resonator includes a silicon substrate (2), a metal film (3) formed on a front surface of the silicon substrate (2), a pair of mount electrodes (5,6) formed on the metal film (3), and an AT-cut type piezoelectric resonator chip (7) that is bump-bonded to the pair of mount electrodes (5,6) to be supported. A linear expansion coefficient of the metal film (3) is $13 \times 10^{-6}$ per degrees centigrade or larger, and a product of the linear expansion coefficient and a Young's modulus of the metal film (3) is 1.95 MPa per degrees centigrade or larger.

## FIG.2

**Description**

The present invention relates to a surface mount device (SMD) type piezoelectric resonator, and more particularly to a piezoelectric resonator for a small package having dimensions of 3.2 mm × 2.5 mm or smaller.

In recent years, in a mobile phone or a personal digital assistant device, a piezoelectric resonator using quartz or the like is used as a time source, a timing source of a control signal or the like, a reference signal source, or the like. There are known various piezoelectric resonators of this type. As one of the piezoelectric resonators, a surface mount device type piezoelectric resonator is known. As this type of piezoelectric resonator, there is generally known a structure including a base substrate on which internal electrodes are formed, and a piezoelectric resonator chip is fixed onto the base substrate with a conductive adhesive and is sealed with a lid substrate. In particular, a through-silicon via method is developed in recent years, and a mounting form is developed in which passive components are mounted on an LSI to have a stack structure (see Japanese Patent Application Laid-open No. 2004-193909).

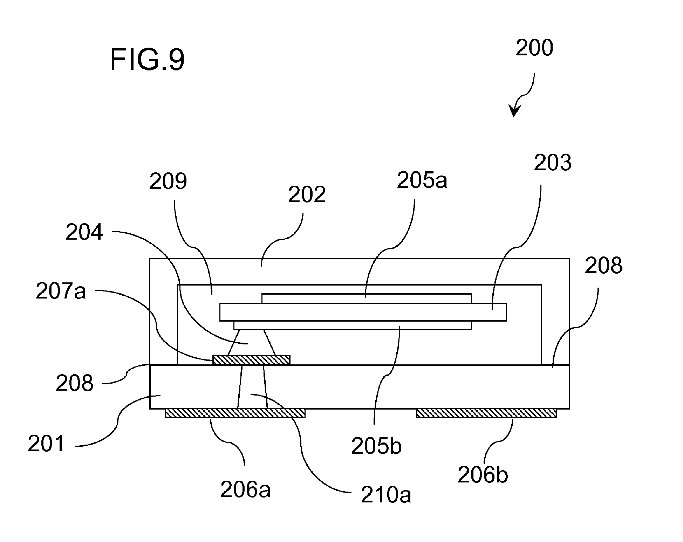

Here, the piezoelectric resonator having the structure in which the piezoelectric resonator chip is fixed onto the silicon substrate is described briefly. As illustrated in FIG. 9, a piezoelectric resonator 200 includes a piezoelectric resonator chip 203, a silicon substrate 201, and a lid substrate 202 that has a recess and is bonded to a bonding surface 208 of the base substrate 201.

The piezoelectric resonator chip 203 is an AT-cut resonator chip made of quartz that is a piezoelectric material. There are formed electrodes 205a and 205b of the resonator chip that sandwich the piezoelectric resonator chip 203 and are patterned so as to vibrate the piezoelectric resonator chip 203. The piezoelectric resonator chip 203 is bonded to an internal electrode 207a formed on the silicon substrate 201 via the electrodes 205a and 205b of the resonator chip, and a conductive adhesive 204.

A recess is formed in the lid substrate 202, which seals the silicon substrate 201 so as to form a cavity 209. The piezoelectric resonator chip 203 is housed in the cavity 209.

On the back surface of the silicon substrate 201, there are formed external electrodes 206a and 206b. Of the external electrodes, the external electrode 206a is electrically connected to the electrode 205b of the resonator chip on one side of the piezoelectric resonator chip 203 via a through-silicon via 210a, the internal electrode 207a, and the conductive adhesive 204. Although not illustrated, the external electrode 206b is electrically connected to the electrode 205a of the resonator chip on the other side of the piezoelectric resonator chip 203 via a through-silicon via (not shown), an internal electrode (not shown), and a conductive adhesive (not shown).

The lid substrate 202 is constituted of a glass substrate or a metal substrate and is bonded to the bonding surface 208 of the silicon substrate 201 by anode bonding or Au-Sn welding, so as to seal the cavity 209.

However, there is a following problem remaining in the conventional piezoelectric resonator 200.

The silicon substrate 201 has a linear expansion coefficient of approximately 2.8 ppm/K. In contrast, a linear expansion coefficient of the AT-cut resonator chip as the piezoelectric resonator chip 203 is $13.7 \times 10^{-6}$ per degrees centigrade in the X axis direction, $9.6 \times 10^{-6}$ per degrees centigrade in the Y axis direction, and $11.6 \times 10^{-6}$ per degrees centigrade in the Z' axis direction, although the values are different a little depending on documents or the like. Therefore, if the piezoelectric resonator chip 203 is mounted on the silicon substrate 201, a large stress is applied to the piezoelectric resonator chip 203 because of a large difference of linear expansion coefficient between the silicon substrate 201 and the piezoelectric resonator chip 203. If a stress is applied to the piezoelectric resonator chip 203, a temperature characteristic changes largely so that a performance thereof is deteriorated.

The present invention is created in view of this circumstance, and it is an object of the present invention to provide a piezoelectric resonator having a structure in which a piezoelectric resonator chip is mounted on a silicon substrate without deteriorating a characteristic.

In order to solve the above-mentioned problem, the present invention provides the following means.

The present invention provides a piezoelectric resonator include: a silicon substrate; a linear expansion coefficient adjusting film formed on a front surface of the silicon substrate; a pair of mount electrodes formed on the linear expansion coefficient adjusting film; and an AT-cut type piezoelectric resonator chip that is bonded to the pair of mount electrodes to be supported, in which a linear expansion coefficient of the linear expansion coefficient adjusting film is $13 \times 10^{-6}$ per degrees centigrade or larger, and a product of the linear expansion coefficient and a Young's modulus of the linear expansion coefficient adjusting film is 1.95 MPa per degrees centigrade or larger. Here, the piezoelectric resonator chip is preferably bump-bonded to the pair of mount electrodes to be supported. Further, the linear expansion coefficient adjusting film may be a metal film, and the piezoelectric resonator may further include an insulator film formed between the linear expansion coefficient adjusting film and the mount electrode. For example, the linear expansion coefficient adjusting film is made of Ni or Cu. Further, the linear expansion coefficient adjusting film may be a quartz film, and the piezoelectric resonator may further include an insulator film formed between the linear expansion coefficient adjusting film and the mount electrode.

The present invention provides an oscillator including: the piezoelectric resonator according the present invention; and an oscillation circuit formed on a front surface of a silicon substrate. Here, the oscillator may further include a protection film formed between a linear expansion coefficient adjusting film and the silicon substrate. Further, the present invention provides an oscillator including: the piezoelectric resonator according to the present invention; and an oscillation circuit formed on a back surface of a silicon substrate. Here, the oscillator may further include a through-silicon via that penetrates the silicon substrate in a thickness direction so as to connect a mount electrode to the oscillation circuit.

The present invention provides an oscillator package including: the oscillator according to the present invention; a package base substrate on which the oscillator is mounted; and a lid substrate that is bonded to a front surface of the package base substrate so that a cavity for housing a piezoelectric resonator chip is formed between the package base substrate and the lid substrate. Further, the present invention provides an oscillator package including: the oscillator according to the present invention; and a lid substrate that is bonded to a front surface of a silicon substrate so that a cavity for housing a piezoelectric resonator chip is formed between the silicon substrate and the lid substrate.

According to the present invention, on the front surface of the silicon substrate, there is formed the linear expansion coefficient adjusting film having the linear expansion coefficient of $13 \times 10^{-6}$ per degrees centigrade or larger, and the product of the linear expansion coefficient and the Young's modulus of 1.95 MPa per degrees centigrade or larger. Therefore, the linear expansion coefficient of the piezoelectric resonator chip may be close to the linear expansion coefficient of the multilayered structural member including the silicon substrate and the linear expansion coefficient adjusting film. Therefore, a stress due to a difference of thermal expansion between the substrate and the piezoelectric resonator chip caused by a change in ambient temperature is reduced. In other words, the deterioration of characteristic due to the temperature characteristic is reduced, so that an effect of reducing a frequency hop or shift from a theoretical curve of a frequency to temperature characteristic is obtained.

Embodiments of the present invention will now be described by way of further example only and with reference to the accompanying drawings, in which:

> FIG. 1 is a top view of a piezoelectric resonator of Embodiment 1 according to the present invention;
> FIG. 2 is a cross section taken along the line A-A of the piezoelectric resonator of Embodiment 1;
> FIG. 3 is a top view of an oscillator of Embodiment 2 according to the present invention;
> FIG. 4 is a cross section taken along the line B-B of the oscillator of Embodiment 2;
> FIG. 5 is a cross section illustrating a packaging form of the oscillator of Embodiment 2;
> FIG. 6 is a cross section of an oscillator of Embodiment 3 according to the present invention;
> FIG. 7 is a cross section illustrating a packaging form of the oscillator of Embodiment 3;
> FIG. 8 is a cross section illustrating a packaging form of an oscillator of Embodiment 4 according to the present invention; and
> FIG. 9 is a cross section of a conventional piezoelectric resonator.

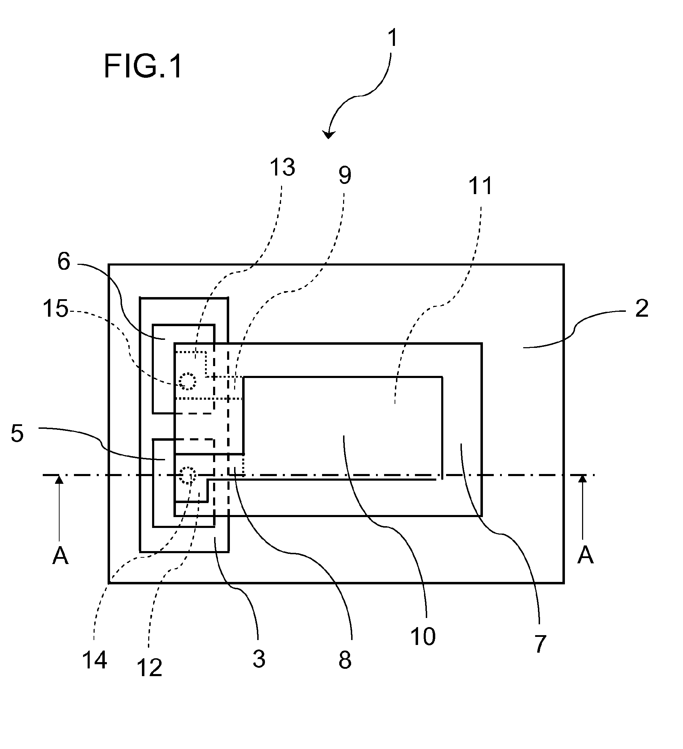

Hereinafter, Embodiments 1 to 4 of a piezoelectric resonator, an oscillator and an oscillator package according to the present invention are described with reference to FIGS. 1 to 8.

[Embodiment 1]

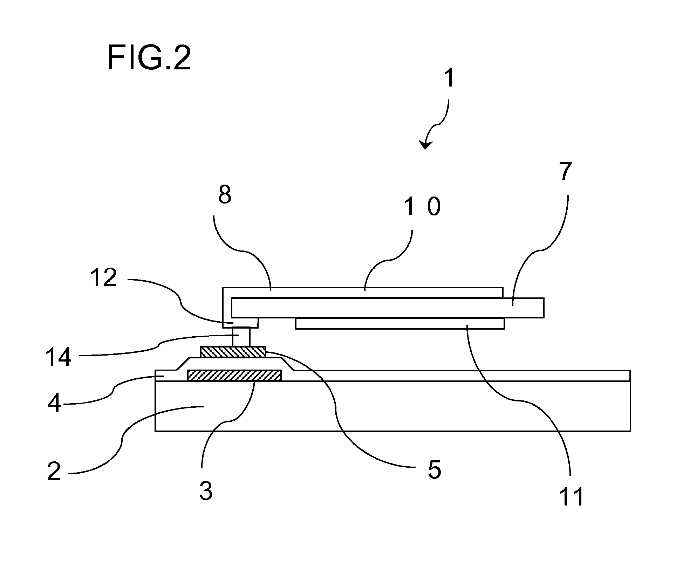

A piezoelectric resonator 1 is, as illustrated in FIGS. 1 and 2, a piezoelectric resonator including a silicon substrate 2 on which a piezoelectric resonator chip 7 is mounted via a metal film (linear expansion coefficient adjusting film) 3 and an insulator film 4. Note that the insulator film 4 is omitted in FIG. 1 for easy recognition.

FIGS. 1 and 2 are referred to for the following description. The piezoelectric resonator chip 7 is an AT-cut type resonator chip in a rectangular thin plate shape formed of quartz as a piezoelectric material, which vibrates when a predetermined voltage is applied. Rectangular electrodes 10 and 11 of the resonator chip are formed respectively on a front surface and a back surface of the piezoelectric resonator chip 7 so as to be opposed to each other in the middle portion. The electrode 10 of the resonator chip formed on the front surface of the piezoelectric resonator chip 7 is connected to a lead electrode 8 at one end portion (lower end portion in FIG. 1) of one short side (left short side in FIG. 1). The lead electrode 8 is formed at one end region (lower region in FIG. 1) of one short side region (left short side region in FIG. 1) on the front surface of the piezoelectric resonator chip 7 and is connected to the electrode 10 of the resonator chip. In addition, this lead electrode 8 is electrically connected to a mount electrode 12 of the resonator chip formed on the back surface of the piezoelectric resonator chip 7 via a side electrode formed on a side face of one short side of the piezoelectric resonator chip 7. The mount electrode 12 of the resonator chip is formed in one end region (lower region in FIG. 1) of one short side region (left short side region in FIG. 1) on the back surface of the piezoelectric resonator chip 7. The electrode 11 of the resonator chip formed on the back surface of the piezoelectric resonator chip 7 is connected to a lead electrode 9 at the other end portion (upper end portion in FIG. 1) of the one short side (left short side in FIG. 1). The lead electrode 9 is formed in the other end region (upper region in FIG. 1) of the one short side region (left short side region in FIG. 1) on the back surface of the piezoelectric resonator chip 7 and is connected to the electrode 11 of the resonator chip. In addition, this lead electrode 9 is electrically connected to a mount electrode 13 of the resonator chip formed on the back surface of the piezoelectric resonator chip 7. The mount electrode 13 of the resonator chip is formed in the other end region (upper region in FIG. 1) of the one short side region (left short side region in FIG. 1) on the back surface of the piezoelectric resonator chip 7. The mount electrodes 12 and 13 of the resonator chip are formed respectively in one end region and the other end region of the one short side region on the back surface of the piezoelectric resonator chip 7, and are respectively connected to bumps 14 and 15 for supporting the piezoelectric resonator chip 7 at two points in the one short side region. The bumps 14 and 15 are respectively connected to mount electrodes 5 and 6 that are formed on the silicon substrate 2 via a metal film 3 and an insulator film 4 that are described later.

Here, the electrodes 10 and 11 of the resonator chip, the mount electrodes 12 and 13 of the resonator chip, the lead electrodes 8 and 9, and the side electrode are formed of coating of conductive film made of, for example, chrome (Cr), nickel (Ni), gold (Au), aluminum (AI), titanium (Ti) or the like, or a lamination film as a combination of some of the conductive films.

On the silicon substrate 2, the metal film (linear expansion coefficient adjusting film) 3 is formed for reducing a difference between a linear expansion coefficient of the piezoelectric resonator chip 7 and a linear expansion coefficient of the silicon substrate 2. The metal film 3 is disposed at a position just under the mount electrodes 5 and 6 to which the bumps 14 and 15 are connected, respectively. The metal film 3 is formed to have a size in a plan view, which includes the two mount electrodes 5 and 6 at the same time. In other words, the two mount electrodes 5 and 6 are formed above the one metal film 3. Note that it is sufficient if the metal film 3 is formed to have a size that is the same as or larger than the size covering the two mount electrodes 5 and 6 at the same time, and so the metal film 3 may be formed over substantially the entire region of the front surface of the silicon substrate 2. On the metal film 3, the insulator film 4 is formed which covers the entire metal film 3 so that the metal film 3 does not become conductive to the mount electrodes 5 and 6. The insulator film 4 is formed on the entire front surface of the silicon substrate 2 in FIG. 2, but it is not necessarily required that the entire front surface of the silicon substrate 2 is covered with the insulator film 4. As long as the state where the metal film 3 is not conductive to the mount electrodes 5 and 6 is secured, it is possible to form the insulator film 4 only in the periphery of the metal film 3. However, the number of process steps is smaller in the case where the insulator film 4 is formed on the entire front surface of the silicon substrate 2.

The piezoelectric resonator chip 7 is bump-bonded to front surfaces of the mount electrodes 5 and 6 via the bumps 14 and 15 made of gold or other metal as illustrated in FIGS. 1 and 2. More specifically, two mount electrodes 12 and 13 of the resonator chip respectively contact with the two bumps 14 and 15 formed on the mount electrodes 5 and 6, and, in this state, the piezoelectric resonator chip 7 is bump-bonded. Thus, the piezoelectric resonator chip 7 is supported on the front surface of the mount electrodes 5 and 6 with a space corresponding to the thickness of the bumps 14 and 15, and the mount electrodes 12 and 13 of the resonator chip are electrically connected to the mount electrodes 5 and 6, respectively. The structure described above is generally referred to as the piezoelectric resonator 1.

Next, the linear expansion coefficient and Young's modulus of the metal film 3 are described. In this embodiment, the linear expansion coefficient of the metal film 3 is $13 \times 10^{-6}$ per degrees centigrade or larger, and the product of the linear expansion coefficient and Young's modulus of the metal film 3 is 1.95 MPa per degrees centigrade or larger. This is a characteristic value that necessarily absorbs a difference between a linear expansion coefficient of the AT-cut resonator chip used as the piezoelectric resonator chip 7 of this embodiment and a linear expansion coefficient of the silicon substrate 2 as a base substrate. The linear expansion coefficient of the AT-cut resonator chip is $13.7 \times 10^{-6}$ per degrees centigrade in the X axis direction, $9.6 \times 10^{-6}$ per degrees centigrade in the Y axis direction, and $11.6 \times 10^{-6}$ per degrees centigrade in the Z' axis direction, although those values are little different depending on documents or the like. On the other hand, the linear expansion coefficient of silicon is approximately $2.8 \times 10^{-6}$ per degrees centigrade. Therefore, if the piezoelectric resonator chip 7 is bump-bonded directly to the silicon substrate 2, a large stress may be applied to the piezoelectric resonator chip 7 because of a large difference between the linear expansion coefficients. If a stress is applied to the piezoelectric resonator chip 7, a malfunction that the frequency changes largely may occur. Note that, as a method of avoiding the above-mentioned malfunction, there is considered a method of making the substrate for bump-bonding with the piezoelectric resonator chip 7 of the same material as the piezoelectric resonator chip 7, or a method of bonding the piezoelectric resonator chip 7 with the substrate with a soft material such as a conductive adhesive. However, in the case of, for example, an oscillator that is described later, it is difficult to adopt the method of making the above-mentioned substrate of the same material as the piezoelectric resonator chip 7. The substrate on which a circuit or the like is formed is usually made of silicon in most cases, and there are few semiconductor materials having the same linear expansion coefficient as the piezoelectric resonator chip 7. In addition, if a conductive adhesive is used for bonding the piezoelectric resonator chip 7 with the substrate, it is very difficult to apply the conductive adhesive onto a very small bonding area. In addition, an adhesive generates gas with time, which may deteriorate reliability of the resonator. Therefore, in this embodiment, the piezoelectric resonator chip 7 is bump-bonded onto the silicon substrate 2, and the metal film 3 is disposed under the mount electrodes 5 and 6 for mounting the piezoelectric resonator chip 7 onto the silicon substrate 2, so as to adjust a difference of linear expansion coefficient between the silicon substrate 2 and the piezoelectric resonator chip 7.

Here, a linear expansion coefficient of two types of materials that are laminated and bonded is calculated. A relational expression (1) of a force is as follows, when a length of the material changes by ΔL in the case where two materials are laminated and bonded.

[Expression 1]

$$\frac{F}{\text{cross - sectional area}} = E \cdot \frac{\Delta L}{L} \qquad \cdots (1)$$

Here, F denotes a force applied to the material, E denotes Young's modulus of the material, L denotes a length of the single material, ΔL denotes a variation of the length of the material when materials are laminated and bonded. In addition, when 'a' denotes a linear expansion coefficient of the material, a length $L_t$ of the material at a certain temperature is expressed as follows.

[Expression 2]

$$L_t = a \cdot \Delta t \cdot L \qquad \cdots (2)$$

Here, Δt denotes a variation of temperature. Therefore, supposing that a material A and a material B are laminated and bonded, and that a length of the laminated and bonded material becomes $L_x$ when the temperature changes by Δt, then the following expressions hold.

[Expression 3]

$$E_A \frac{a_A \cdot \Delta t \cdot L - L_X}{a_A \cdot \Delta t \cdot L} = \frac{F_A}{S_A} \qquad \cdot \cdot \cdot \quad (3)$$

[Expression 4]

$$E_B \frac{a_B \cdot \Delta t \cdot L - L_X}{a_B \cdot \Delta t \cdot L} = \frac{F_B}{S_B} \qquad \cdot \cdot \cdot \quad (4)$$

Because the material A and the material B are laminated and bonded while forces are balanced, the following expression holds.

[Expression 5]

$$F_A + F_B = 0 \qquad \cdot \cdot \cdot \quad (5)$$

From the expressions (3), (4) and (5), the length $L_x$ of the material A is derived as follows, where $S_A$ denotes a cross-sectional area of the material A, and $S_B$ denotes a cross-sectional area of the material B.

[Expression 6]

$$L_X = \frac{a_A \cdot a_B (E_A \cdot S_A + E_B \cdot S_B)}{E_A \cdot S_A \cdot a_B + E_B \cdot S_B \cdot aA} \Delta t \cdot L \qquad \cdots \quad (6)$$

From the expression (6), the linear expansion coefficient when the two materials are laminated and bonded is expressed as follows.

[Expression 7]

$$\frac{a_A \cdot a_B (E_A \cdot S_A + E_B \cdot S_B)}{E_A \cdot S_A \cdot a_B + E_B \cdot S_B \cdot aA} \qquad \cdots \quad (7)$$

A linear expansion ratio and Young's modulus of the silicon substrate 2 is substituted into this expression (7), and further it is supposed that the film thickness of the metal film 3 is 5 $\mu$m that is generally used in plating or the like, the thickness of the silicon substrate 2 is 50 $\mu$m, and the target linear expansion coefficient is $3.8 \times 10^{-6}$ per degrees centigrade that is one third of the linear expansion coefficient of the quartz resonator chip in the Z' axis direction. Then, the linear expansion coefficient and the Young's modulus of the metal film 3 are determined. The linear expansion coefficient of the metal film 3 is $13 \times 10^{-6}$ per degrees centigrade or larger. In addition, when the product of the linear expansion coefficient and the Young's modulus of the metal film 3 is 1.95 MPa per degrees centigrade or larger, the linear expansion coefficient of $3.8 \times 10^{-6}$ per degrees centigrade is satisfied. Here, the linear expansion coefficient of the silicon substrate 2 is $2.8 \times 10^{-6}$ per degrees centigrade, and the Young's modulus of the same is 130 GPa. Ni and Cu satisfy the above-mentioned value as a general metal.

As described above, it is understood that the metal film 3 formed on the silicon substrate 2 is a material having a characteristic value satisfying the condition that the linear expansion coefficient is $13 \times 10^{-6}$ per degrees centigrade or larger and that the product of the linear expansion coefficient and the Young's modulus is 1.95 MPa per degrees centigrade or larger. In addition, satisfying metals under this condition are Ni and Cu. In this embodiment, a thickness of the metal film 3 is set to 5 $\mu$m, and a thickness of the silicon substrate 2 is set to 50 $\mu$m. However, if the thickness of the metal film 3 is set to 5 $\mu$m or larger, or if the thickness of the silicon substrate 2 is set to 50 $\mu$m or smaller, a limit range of the linear expansion coefficient or the Young's modulus of the metal film 3 is expanded. However, considering an operable condition, it would be reasonable that the linear expansion coefficient of the metal film 3 should be $13 \times 10^{-6}$ per degrees centigrade or larger and that the product of the linear expansion coefficient and the Young's modulus of the metal film 3 is 1.95 MPa per degrees centigrade or larger. Note that it is preferable that the linear expansion coefficient of the metal film 3 is $30 \times 10^{-6}$ per degrees centigrade or smaller and that the product of the linear expansion coefficient and the Young's modulus of the metal film 3 is 2.5 MPa per degrees centigrade or smaller.

Because the metal film 3 as the above-mentioned linear expansion coefficient adjusting film is formed, the linear expansion coefficient of the piezoelectric resonator chip 7 may be close to the linear expansion coefficient of the multilayered structural member including the silicon substrate 2, the metal film 3 and the insulator film 4. Therefore, the stress due to a difference of thermal expansion between the silicon substrate 2 and the piezoelectric resonator chip 7 caused by a change in ambient temperature may be reduced. In other words, characteristic deterioration due to a temperature characteristic is decreased, so that an effect of reducing a frequency hop or shift from a theoretical curve of a frequency to temperature characteristic may be obtained.

In addition, because the bump bonding of the piezoelectric resonator chip 7 is adopted in this embodiment, the conventional problem accompanying downsizing may be solved. More detail description is given as follows. Accompanying downsizing of the piezoelectric resonator, the mount electrodes 12 and 13 of the resonator chip 7 become small, and it is necessary to decrease also the bonding region of the conductive adhesive that is usually used. However, the conductive adhesive has fluidity and is hardly retained within a constant region and may be spread to the entire region. Therefore, it is difficult to decrease the bonding region (i.e., the size of the mount electrodes 12 and 13 of the resonator chip). On the other hand, it is also considerable to increase the size of the mount electrodes 12 and 13 of the resonator chip for securing the bonding region. In this case, however, the electrodes 10 and 11 of the resonator chip may become small so that a region of a vibrating part of the piezoelectric resonator chip 7 may become small, resulting in deterioration of the characteristic. In contrast, this embodiment adopts the bump bonding so that the area of the bonding region may be very small. Therefore, the vibration region of the piezoelectric resonator chip 7 may be large, so it is possible to improve impedance characteristic and to facilitate designing the piezoelectric resonator chip 7. The bump bonding may be ultrasonic bonding of metal and has an effect that the piezoelectric resonator chip 7 and the silicon substrate 2 may be bonded to each other securely to have very high resistance against an impact despite the very small area of the bonding region. Because of such strong bonding, there may be a large stress applied to the piezoelectric resonator chip 7 due to a difference between the linear expansion coefficient of the silicon substrate 21 and the linear expansion coefficient of the piezoelectric resonator chip 7. However, this problem may be solved by providing the above-mentioned metal film 3.

In addition, because it needs a long time to cure the conductive adhesive, in the assembly process, it is necessary to retain the piezoelectric resonator chip 7, or it is necessary to bond the piezoelectric resonator chip 7 in an inclined posture in advance so that the piezoelectric resonator chip 7 becomes parallel to the silicon substrate 2 by the weight of itself when the conductive adhesive is cured. However, such time-consuming bonding method is not necessary if the bump bonding is adopted as this embodiment. In addition, because the piezoelectric resonator chip 7 is supported by the bump bonding with a space from the silicon substrate 2, a minimum vibration gap that is necessary for vibration may be naturally secured. Therefore, the thickness of the silicon substrate 2 may be as thin as possible. In this point, Embodiment 1 may reduce the thickness of the piezoelectric resonator 1. Further, because the bump ball does not generate outgas in a long term use, there is obtained an effect that the stable characteristic of the piezoelectric resonator 1 may be maintained in a long term as the effect. Further, because the bump ball does not change with time depending on thermal environment, the stable characteristic of the piezoelectric resonator 1 may be maintained in a long term.

[Embodiment 2]

A structure and effects of Embodiment 2 are substantially the same as those described above in Embodiment 1, but Embodiment relates to an oscillator, and an oscillation circuit is formed on silicon substrate 2 as a large difference. Therefore, description of the same structure as Embodiment 1 is omitted, and the difference is described.

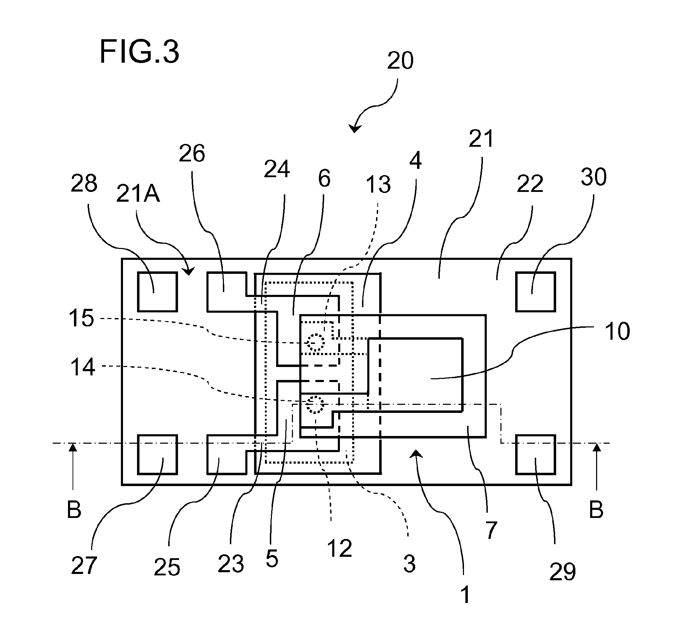

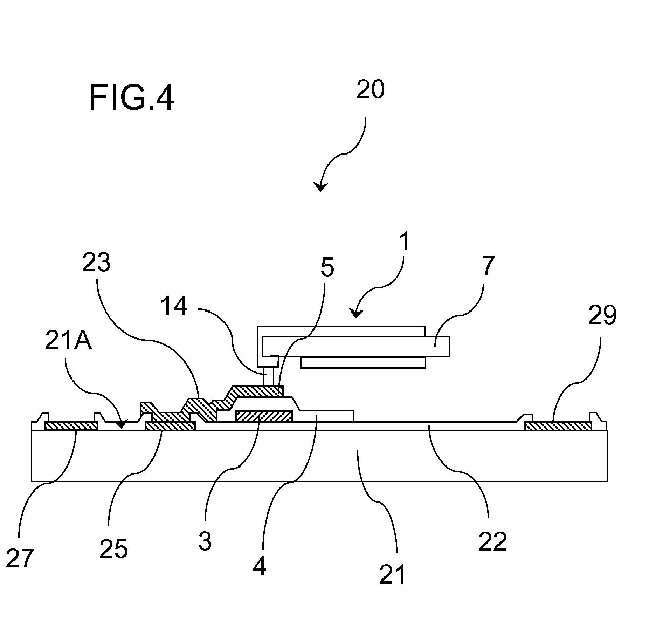

An oscillator 20 utilizing the piezoelectric resonator 1 of Embodiment 1 described above is illustrated in FIGS. 3 and 4. On the front surface of the silicon substrate 21, there are formed an oscillation circuit 21A, connection terminals 25 and 26 of the piezoelectric resonator, and electrode terminals 27, 28, 29 and 30 of the oscillation circuit. In addition, on the front surface of the silicon substrate 21, there are formed a protection film 22 constituted of an oxide film or a nitride film with openings corresponding to portions of the connection terminals 25 and 26 of the piezoelectric resonator and the electrode terminals 27, 28, 29 and 30 of the oscillation circuit. The metal film 3 is formed on the protection film 22, and the insulator film 4 is formed to cover the metal film 3. The metal film 3 is disposed at a position just below the mount electrodes 5 and 6, and is formed to have a size that is the same as or larger than the size covering the two mount electrodes 5 and 6 at the same time. The insulator film 4 covers the entire metal film 3 so that the metal film 3 is not conductive to the mount electrodes 5 and 6. In FIGS. 3 and 4, the insulator film 4 is formed only in the periphery of the metal film 3, but this structure should not be interpreted as a limitation. As long as the state where the metal film 3 and the mount electrodes 5 and 6 are not conductive to each other may be maintained, the insulator film 4 may be formed on the entire substrate except for openings at portions of the connection terminals 25 and 26 of the piezoelectric resonator and the electrode terminals 27, 28, 29 and 30 of the oscillation circuit. Although depending on a process method, the number of the process steps is generally fewer if the insulator film 4 is formed on the entire surface of the silicon substrate 21.

When the mount electrodes 5 and 6 are formed on the insulator film 4 and above the metal film 3, connection electrodes 23 and 24 for connecting the connection terminals 25 and 26 of the piezoelectric resonator on the silicon substrate 21 with the mount electrodes 5 and 6 are formed simultaneously. The piezoelectric resonator chip 7 is bump-bonded on the mount electrodes 5 and 6 by using bumps 14 and 15 made of gold or other metal as illustrated in FIGS. 3 and 4. Thus, the piezoelectric resonator chip 7 is supported with a space from the front surface of the mount electrodes 5 and 6 corresponding to the thickness of the bumps 14 and 15. In addition, the mount electrodes 12 and 13 of the resonator chip, the mount electrodes 5 and 6, the connection electrodes 23 and 24, and the connection terminals 25 and 26 of the piezoelectric resonator are electrically connected to each other, respectively. When a voltage is applied to the oscillation circuit electrode terminal, the oscillation circuit 21A supplies excitation current to the piezoelectric resonator chip 7 via the connection terminal 25 of the piezoelectric resonator, and receives a resonance signal from the connection terminal 26 of the piezoelectric resonator so as to sustain the oscillation. Then, it may be used as a timing source of a control signal or a reference signal source or the like, utilizing the oscillation.

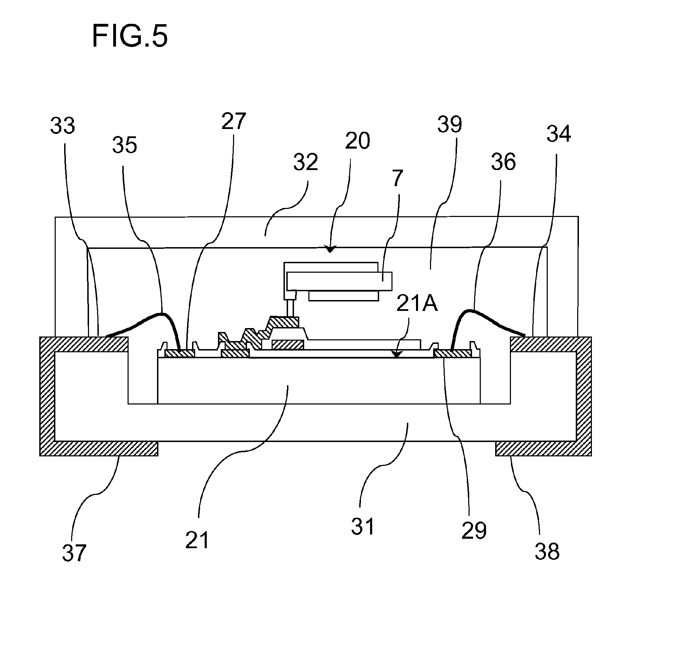

In addition, FIG. 5 illustrates a state of housing the oscillator 20 of Embodiment 2 in a package. The package base substrate 31 is made of ceramic or the like and is formed in a recess shape. The oscillator 20 described above in Embodiment 2 is mounted on the bottom surface of the recess of the package base substrate 31. Bonding pads 33 and 34 are formed on the front surface of the package base substrate 31 in the region except for the recess, and package external electrodes 37 and 38 are formed on the back surface of the package base substrate 31. In addition, on the package base substrate 31, there is also formed an internal electrode pattern for connecting the bonding pads 33 and 34 to the package external electrodes 37 and 38, respectively. After that, the bonding pads 33 and 34 formed on the package base substrate 31 are bonded to the electrode terminals 27, 28, 29 and 30 of the oscillation circuit on the silicon substrate 21 with wires 35 and 36 (electrode terminals 28 and 30 of the oscillation circuit are not illustrated in FIG. 5). Thus, a voltage is applied to the oscillation circuit 21A, and excitation current is supplied to the piezoelectric resonator chip 7, so that the piezoelectric resonator chip 7 oscillates. The excitation current flowing back from the piezoelectric resonator chip 7 is rectified by the oscillation circuit 21A, and a signal is output to the outside of the package via the electrode terminals 27 and 29 of the oscillation circuit, the wires 35 and 36, the bonding pads 33 and 34, and the package external electrodes 37 and 38.

A lid substrate 32 having a recess is bonded to the front surface of the package base substrate 31 on which the oscillator 20 is mounted, in a nitride atmosphere or in a vacuum atmosphere, so that the inside of a cavity 39 of the package is sealed in an airtight manner.

Thus, in this embodiment, the silicon substrate 21 on which the oscillation circuit 21A is formed and the piezoelectric resonator chip 7 are integrated to one unit. Therefore, it is not necessary to provide the mounting space of the silicon substrate 21 on which the oscillation circuit 21A is formed and the mounting space of the piezoelectric resonator chip 7 individually unlike the conventional oscillator package. Thus, thickness of the oscillator package may be reduced, and cost reduction may also be realized. Further, the piezoelectric resonator chip 7 and the silicon substrate 21 are very close to each other. Therefore, for example, in the case of a temperature compensation type oscillation circuit, the temperature sensor may measure the temperature of the piezoelectric resonator chip 7 more precisely, so that accurate temperature compensation may be performed.

[Embodiment 3]

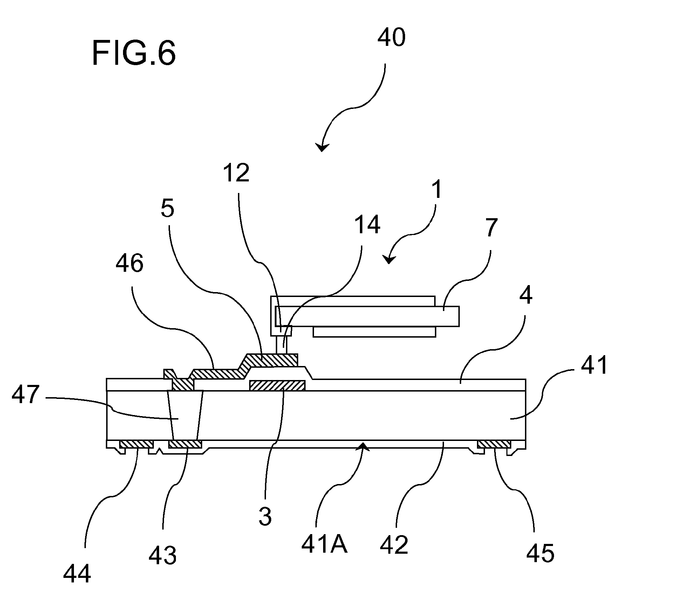

A structure and effects of Embodiment 3 are substantially the same as those described above in Embodiment 1 and Embodiment 2, but Embodiment 3 has a large difference in that the oscillation circuit is formed on the back surface of the silicon substrate, and the piezoelectric resonator chip 7 is mounted on the front surface of the silicon substrate. Therefore, description of the same structure as Embodiment 1 and Embodiment 2 is omitted, and the difference is described. FIG. 6 is a cross sectional view and illustrates only a part of the connection terminals of the piezoelectric resonator or the electrode terminals of the oscillation circuit, but the actual structure thereof is the same as that of Embodiment 2.

In an oscillator 40 illustrated in FIG. 6, an oscillation circuit 41A, a terminal 43 connected with a piezoelectric resonator, and electrode terminals 44 and 45 of the oscillation circuit are formed on the back surface of a silicon substrate 41. On the back surface of the silicon substrate 41, there is formed a protection film 42 constituted of an oxide film or a nitride film with openings corresponding to portions of the electrode terminals 44 and 45 of the oscillation circuit. A through-silicon via 47 is formed in the silicon substrate 41 at the portion where the terminal 43 connected with a piezoelectric resonator is formed, so that the terminal 43 connected with a piezoelectric resonator and the through-silicon via 47 are electrically connected to each other. In addition, a connection electrode 46 formed on the front surface of the silicon substrate 41 and the through-silicon via 47 are electrically connected to each other. The metal film 3 is formed on the front surface of the silicon substrate 41. The metal film 3 is formed at the position just below the mount electrode 5 and has a size that is the same as or larger than the size covering the two mount electrodes at the same time. The insulator film 4 covers the entire metal film 3 so that the metal film 3 and the mount electrode 5 are not conductive to each other. In FIG. 6, the entire front surface of the silicon substrate 41 is covered with the insulator film 4, but it is not necessarily required that the entire surface of the substrate is covered with the insulator film 4. As long as the state where the metal film 3 and the two mount electrodes 5 are not conductive to each other may be maintained, the insulator film 4 may cover only in the periphery of the metal film 3. However, the number of process steps is generally smaller in the case where the insulator film 4 is formed on the entire front surface of the silicon substrate 41.

When the mount electrode 5 is formed on the insulator film 4 and above the metal film 3, connection electrodes 46 for connecting the through-silicon via 47 of the silicon substrate 41 with the mount electrode 5 is formed simultaneously. The piezoelectric resonator chip 7 is bump-bonded on the front surface of the mount electrode 5 by using bump 14 made of gold or other metal as illustrated in FIG. 6. Thus, the piezoelectric resonator chip 7 is supported with a space from the front surface of the mount electrode 5 corresponding to the thickness of the bump 14. In addition, the mount electrode 12 of the resonator chip, the mount electrode 5, the connection electrodes 46, the through-silicon via 47, and the terminals 43 connected with a piezoelectric resonator are electrically connected to each other, respectively. The structure described above is generally referred to as the oscillator 40. When a voltage is applied to the electrode terminals 44 and 45 of the oscillation circuit, the oscillation circuit 41A supplies excitation current to the piezoelectric resonator chip 7 via the terminal 43 connected with a piezoelectric resonator, and receives a resonance signal from the piezoelectric resonator chip 7 so as to sustain the oscillation. Then, it may be used as a timing source of a control signal or a reference signal source or the like, utilizing the oscillation.

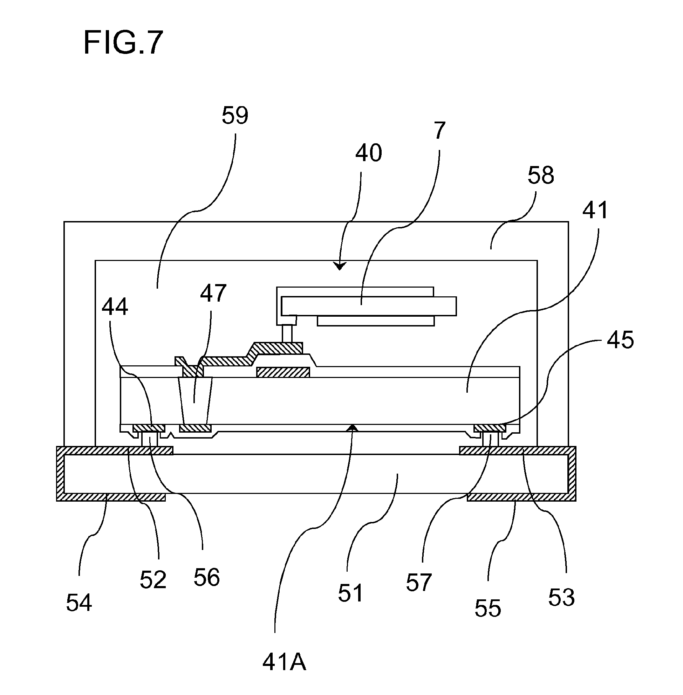

In addition, FIG. 7 illustrates a state of housing the oscillator 40 of Embodiment 3 in a package. The package base substrate 51 is made of ceramic or the like and is formed in a plate shape. Bonding pads 52 and 53 for an oscillation circuit are formed on the front surface of the package base substrate 51, and package external electrodes 54 and 55 are formed on the back surface of the package base substrate 51. In addition, on the package base substrate 51, there is also formed an internal electrode pattern for connecting the bonding pads 52 and 53 to the package external electrodes 54 and 55, respectively. Bumps 56 and 57 are provided to the electrode terminals 44 and 45 of the oscillation circuit on the back surface of the silicon substrate 41, and the oscillator 40 is flip-chip mounted to the bonding pads 52 and 53 on the package base substrate 51. Thus, a voltage is applied to the oscillation circuit 41A, and excitation current is supplied to the piezoelectric resonator chip 7, so that the piezoelectric resonator chip 7 oscillates. The excitation current flowing back from the piezoelectric resonator chip 7 is rectified by the oscillation circuit 41A, and a signal is output to the outside of the package via the electrode terminals 45 of the oscillation circuit, the bump 57, the bonding pad 53, and the package external electrode 55.

A lid substrate 58 having a recess is bonded to the front surface of the package base substrate 51 on which the oscillator 40 is mounted, in a nitride atmosphere or in a vacuum atmosphere, so that the inside of a cavity 59 of the package is sealed in an airtight manner.

Thus, in this embodiment, the silicon substrate 41 on which the oscillation circuit 41A is formed and the piezoelectric resonator chip 7 are integrated to one unit. Therefore, it is not necessary to provide the mounting space of the silicon substrate 21 on which the oscillation circuit is formed and the mounting space of the piezoelectric resonator chip individually unlike the conventional oscillator package. Thus, thickness of the oscillator package may be reduced, and cost reduction may also be realized. In addition, a space for wire bonding is not required, and a smaller package may be created. Further, the piezoelectric resonator chip 7 and the silicon substrate 41 are very close to each other. Therefore, for example, in the case of a temperature compensation type oscillation circuit, the temperature sensor may measure the temperature of the piezoelectric resonator chip 7 more precisely, so that accurate temperature compensation may be performed.

[Embodiment 4]

As to Embodiment 4 too, overlapping description is omitted, and only a difference is described.

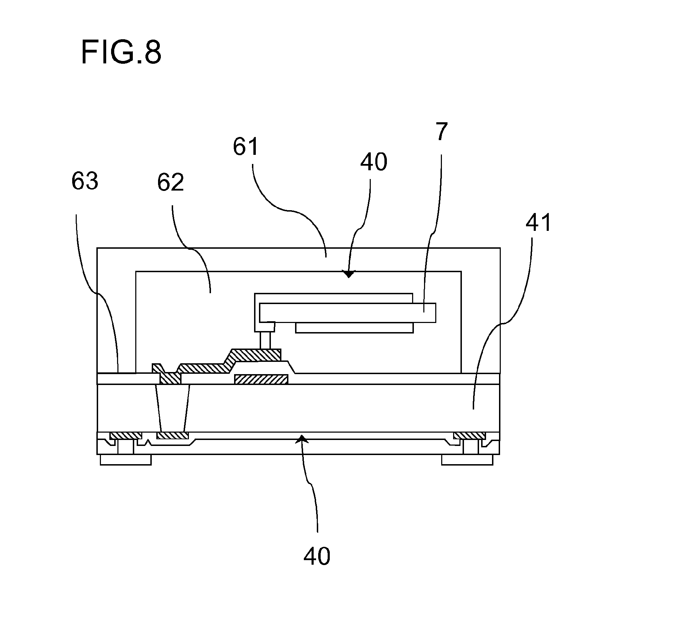

Embodiment 4 is a form in which the oscillator 40 of Embodiment 3 is housed in a package as illustrated in FIG. 8. A lid substrate 61 formed in a shape having a recess is bonded to the front surface of the silicon substrate 41 of the oscillator 40 so as to enclose the piezoelectric resonator chip 7. The lid substrate 61 is bonded to the front surface of the silicon substrate 41 in a nitride atmosphere or in a vacuum atmosphere, so that the inside of a cavity 62 of the package is sealed in an airtight manner. The lid substrate 61 is made of metal, semiconductor, or glass. In the case of metal, Au-Sn bonding or the like is used for bonding to the silicon substrate 41. In the case of semiconductor or glass, anode bonding may be used besides the Au-Sn bonding.

Here, an effect of the anode bonding is described. If the anode bonding is used for bonding the silicon substrate 41 to the lid substrate 61, the silicon substrate 41 on which a plurality of oscillation circuits are arranged like an array and a plurality of piezoelectric resonator chips 7 may be bonded and sealed in an airtight manner at the same time. Very high pressure is usually applied to the silicon substrate 41 in the bonding process. If a plurality of units are bonded simultaneously as the above-mentioned anode bonding, the pressure applied to each of the silicon substrates 41 and the lid substrates 61 in the bonding process is reduced, so that breakage or chipping does not occur even if the bonding surface is small. In particular, according to the experiment result up to now, it is confirmed that if the width of the bonding surface 63 between the silicon substrate 41 and the lid substrate 61 is set to 50 $\mu$m or larger, the bonding may be performed while maintaining airtightness of the inside of the cavity 62. In addition, according to the experiment, even if the width of the bonding surface 63 of the anode bonding is set to 300 $\mu$m or larger, no change was observed in characteristics of airtightness and durability. Therefore, it may be said that a desirable range of the width of the bonding surface 63 between the silicon substrate 41 and the lid substrate 61 in this embodiment is 50 to 300 $\mu$m.

In addition, if the width of the bonding surface 63 is decreased, a size of the cavity 62 may be large so that a size of the piezoelectric resonator chip 7 may be increased. If the size of the piezoelectric resonator chip 7 is increased, crystal impedance of the piezoelectric resonator chip 7 is decreased so that the performance is improved. Further, in the case of the anode bonding, there is little gas that is generated in the bonding process. Therefore, the airtightness inside the cavity 62 may be maintained, and a characteristic change of the piezoelectric resonator chip 7 with time is decreased.

In the manufacturing method of the piezoelectric resonator and the oscillator according to this embodiment, a plurality of piezoelectric resonators or oscillators may be manufactured simultaneously, so cost reduction may be realized.

Note that the technical scope of the present invention is not limited to Embodiment 1 to Embodiment 4 described above, which may be modified variously without deviating from the scope of the present invention. For instance, the case of using the metal film 3 as the linear expansion coefficient adjusting film is described in Embodiments 1 to 4 described above, but this structure should not be interpreted as a limitation. For instance, instead of the metal film 3 in Embodiments 1 to 4, as the linear expansion coefficient adjusting film, it is possible to use a quartz plate made of the same material as the piezoelectric resonator chip 7 made of quartz. In this case, the quartz plate as a linear expansion coefficient adjusting film has the same linear expansion coefficient as the piezoelectric resonator chip 7 made of quartz, as a matter of course. Therefore, the linear expansion coefficient of the piezoelectric resonator chip 7 may be close to the linear expansion coefficient of the multilayered structural member including the silicon substrate 2, the linear expansion coefficient adjusting film made of the quartz plate, and the insulator film 4, so that the same effect as Embodiments 1 to 4 described above may be obtained.

The foregoing description has been given by way of example only and it will be appreciated by a person skilled in the art that modifications can be made without departing from the scope of the present invention.

**Claims**

1. A piezoelectric resonator (1), comprising:

   a silicon substrate (2);
   a linear expansion coefficient adjusting film (3) formed on a front surface of the silicon substrate;
   a pair of mount electrodes (5, 6) formed on the linear expansion coefficient adjusting film; and
   an AT-cut type piezoelectric resonator chip (7) that is bonded to the pair of mount electrodes to be supported, wherein a linear expansion coefficient of the linear expansion coefficient adjusting film is $13 \times 10^{-6}$ per degrees centigrade or larger, and a product of the linear expansion coefficient and a Young's modulus of the linear expansion coefficient adjusting film is 1.95 MPa per degrees centigrade or larger.

2. A piezoelectric resonator according to claim 1, wherein the piezoelectric resonator chip is bump-bonded to the pair of mount electrodes to be supported.

3. A piezoelectric resonator according to claim 1, wherein
   the linear expansion coefficient adjusting film is a metal film, and
   the piezoelectric resonator further comprises an insulator film (4) formed between the linear expansion coefficient adjusting film and the mount electrode.

4. A piezoelectric resonator according to claim 3, wherein the linear expansion coefficient adjusting film is made of Ni or Cu.

5. A piezoelectric resonator according to claim 1 or claim 2, wherein
   the linear expansion coefficient adjusting film is a quartz film, and
   the piezoelectric resonator further comprises an insulator film formed between the linear expansion coefficient adjusting film and the mount electrode.

6. An oscillator, comprising:

   the piezoelectric resonator according to any one of the preceding claims; and
   an oscillation circuit (21A) formed on a front surface of a silicon substrate.

7. An oscillator according to claim 6, further comprising a protection film (22) formed between a linear expansion coefficient adjusting film and the silicon substrate.

8. An oscillator, comprising:

   the piezoelectric resonator according to any one of the preceding claims; and
   an oscillation circuit (41A) formed on a back surface of a silicon substrate.

9. An oscillator according to claim 8, further comprising a through-silicon via (47) that penetrates the silicon substrate in a thickness direction so as to connect a mount electrode to the oscillation circuit.

10. An oscillator package, comprising:

the oscillator according to claim 6 or claim 7;

a package base substrate (31) on which the oscillator is mounted; and

a lid substrate (32) that is bonded to a front surface of the package base substrate so that a cavity (39) for housing a piezoelectric resonator chip is formed between the package base substrate and the lid substrate.

**11.** An oscillator package (200), comprising:

the oscillator according to claim 8 or claim 9; and

a lid substrate (202) that is bonded to a front surface of a silicon substrate so that a cavity (209) for housing a piezoelectric resonator chip is formed between the silicon substrate and the lid substrate.

FIG.1

FIG.2

FIG.3

FIG.4

FIG.5

FIG.6

## FIG.7

FIG.8

FIG.9

Europäisches
Patentamt

European
Patent Office

Office européen
des brevets

# EUROPEAN SEARCH REPORT

Application Number

EP 10 17 4764

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2000 196360 A (KINSEKI LTD) 14 July 2000 (2000-07-14) | 1,2,6-11 | INV. H03H9/05 H03H9/10 |
| A | * abstract; figures 1a,b * * paragraphs [0010], [0015], [0016], [0021] * | 3-5 | |
| A | JP 11 145728 A (NEC CORP) 28 May 1999 (1999-05-28) * abstract; figures 1,4,5 * | 6,7,10 | |
| A | US 2006/055479 A1 (OKAZAKI MASAYOSHI [JP] ET AL) 16 March 2006 (2006-03-16) * abstract; figures 1,4,8,15 * | 6,7,10 | |
| A | JP 5 121989 A (SEIKO EPSON CORP) 18 May 1993 (1993-05-18) * paragraph [0024]; figures 3,4 * | 8,9,11 | |
| A | JP 2006 129417 A (KYOCERA CORP; KYOCERA KINSEKI CORP) 18 May 2006 (2006-05-18) * abstract; figure 2 * | 8,9,11 | TECHNICAL FIELDS SEARCHED (IPC) |
| A | US 2007/120614 A1 (MORIYA KOUICHI [JP] ET AL) 31 May 2007 (2007-05-31) * paragraphs [0088] - [0090]; figures 17A,B * | 1-11 | H03H H03B |
| A | JP 8 162893 A (MATSUSHITA ELECTRIC IND CO LTD) 21 June 1996 (1996-06-21) * paragraphs [0014] - [0017], [0039]; figure 2 * | 1-11 | |

The present search report has been drawn up for all claims

| Place of search | Date of completion of the search | Examiner |
|---|---|---|
| Munich | 17 November 2010 | Maget, Judith |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 17 4764

This annex lists the patent family members relating to the patent documents cited in the above-mentioned European search report.
The members are as contained in the European Patent Office EDP file on
The European Patent Office is in no way liable for these particulars which are merely given for the purpose of information.

17-11-2010

| Patent document cited in search report | | Publication date | Patent family member(s) | | Publication date |
|---|---|---|---|---|---|
| JP 2000196360 | A | 14-07-2000 | JP | 4294135 B2 | 08-07-2009 |
| JP 11145728 | A | 28-05-1999 | JP | 3125732 B2 | 22-01-2001 |
| US 2006055479 | A1 | 16-03-2006 | JP | 2006129455 A | 18-05-2006 |
| JP 5121989 | A | 18-05-1993 | NONE | | |
| JP 2006129417 | A | 18-05-2006 | JP | 4545004 B2 | 15-09-2010 |
| US 2007120614 | A1 | 31-05-2007 | US | 2010013565 A1 | 21-01-2010 |
| | | | US | 2010026398 A1 | 04-02-2010 |
| JP 8162893 | A | 21-06-1996 | NONE | | |

**EP 2 306 643 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004193909 A